# EUROPEAN PATENT SPECIFICATION

(11) **EP 2 146 250 B1**
(45) Date of publication and mention of the grant of the patent: **23.08.2017**
(21) Application number: 08752271.0
(22) Date of filing: 01.05.2008
(51) Int. Cl.: G03F 7/40, H01L 21/027

(54) **WATER-SOLUBLE RESIN COMPOSITION FOR THE FORMATION OF MICROPATTERNS AND PROCESS FOR THE FORMATION OF MICROPATTERNS WITH THE SAME**
WASSERLÖSLICHE HARZZUSAMMENSETZUNG ZUR BILDUNG VON MIKROSTRUKTUREN UND VERFAHREN ZUR BILDUNG VON MIKROSTRUKTUREN DAMIT
COMPOSITION DE RÉSINE SOLUBLE DANS L'EAU POUR LA FORMATION DE MICRO-MOTIFS ET PROCESSUS DE FORMATION DE MICRO-MOTIFS AVEC CELLE-CI

(30) Priority: 01.05.2007 JP 2007120833
(43) Date of publication of application: 20.01.2010
(73) Proprietor: Merck Patent GmbH, 64293 Darmstadt (DE)
(72) Inventor: HONG, Sung-Eun, Somerville, New Jersey 08876 (US); TAKANO, Yusuke, Kakegawa-shi Shizuoka 437-1412 (JP); KANG, Wen-Bing, Kakegawa 436-0054 (JP)
(74) Representative: Rippel, Hans Christoph
(86) International application number: PCT/JP2008/058341
(87) International publication number: WO 2008/136499

(56) References cited:
- EP-A1- 1 385 059
- EP-A1- 1 398 671
- EP-A2- 0 780 418
- WO-A1-2005/008340
- WO-A1-2005/098545
- WO-A1-2006/019135
- WO-A2-2008/122884
- JP-A- 2003 215 814
- JP-A- 2003 251 954
- JP-A- 2006 106 295

## Description

### TECHNICAL FIELD

The present invention relates to a water-soluble resin composition for the formation of fine patterns, which enables the effective scale-down of separation size and hole opening size of a resist pattern to a level finer than the limit of resolution of the wave length of exposure when forming a resist pattern in a production process of a semiconductor or the like, wherein the water-soluble resin composition is applied on a resist pattern to form a coated layer, the coated layer adjacent to the resist pattern is modified through mixing to form on a surface of the resist pattern a modified layer that is not able to be removed by water washing, thereby the resist pattern being thickened. Further, the present invention also relates to a method for forming fine patterns with the water-soluble resin composition for the formation of fine patterns. Herein, the mixing indicates that a coated layer and a resist mix and includes one accompanying a chemical reaction.

### BACKGROUND ART

In various fields including a production of semiconductor devices such as LSIs, a preparation of display screens for display devices such as liquid crystal display devices, and the like, a photolithographic technology has been used in order to form a fine element or conduct a fine processing. When resist patterns are formed by a photolithographic technology, various positive- or negative-working radiation sensitive resin compositions have been used. With high integration of semiconductor devices and the like, a line width of a wire and a distance between wires required in the manufacturing process of the device come to be further fine. In order to respond the requirement, shorter wavelength light has been used for the exposure to make a resist pattern finer or improvements of exposing units have been conducted. In particular in recent years, when a pattern with 60 nm or less is formed by an ordinary photolithographic process, it has been necessary to use an immersion photolithography. However, a vast capital investment is necessary to respond to the immersion photolithography. Under such situations, various technologies for forming fine resist patterns without introducing new equipment, that is, by utilizing the conventional equipment, have been developed. Among these technologies, a technology most close to practical use at present is a technology that, irrespective of an exposure wavelength, is capable of forming a fine pattern with a finer size than that of a limit of resolution on the photolithography by miniaturizing or shrinking effectively separation size, hole opening size and the like of a resist pattern to a level equal to or finer than the limit of resolution of the wave length used on exposure. Such a technology does not have a long history and depends on researches carried out during recent 10 years or so.

Some examples of a resist pattern shrinking technology that is capable of forming a fine pattern with a finer size than that of a resolution limit on the photolithography irrespective of the exposure wavelength include: a pattern forming method which comprises forming a resist pattern, applying thereon a resist for generating mixing, baking it to form a mixing layer, and developing the layer into a fine pattern size (JP-A No. 5-166717); a method which comprises forming a positive photoresist pattern on a substrate, radiating electromagnetic radiation evenly, applying thereon an aqueous paint evenly and dissolving and peeling (lifting off) the positive photoresist with an aqueous alkaline solution to form a fine pattern of aqueous paint (JP-A. No. 7-191214) ; a method which comprises covering a resist pattern containing a material that generates an acid by exposure with a resist containing a material that can crosslink under presence of an acid, and making an acid generate in the resist pattern by heating or by exposing to form a crosslinked layer generated in an interface as a coated layer of the resist pattern to thicken the resist pattern, thereby a hole diameter in the resist pattern and a separation distance between the resist patterns being shrunk (JP-A No. 10-73927); a method which comprises making a chemical liquid containing a crosslinking agent that generates crosslinkings under the presence of acid and a swelling promoter permeate into a surface layer portion of a resist pattern to swell the surface layer portion and making a crosslinked film form in the swollen surface layer portion of the resist pattern to form a second resist pattern (JP-A No. 2001-100428); a resist pattern forming method which comprises applying a surfactant-containing solution and applying a resist pattern thickening material containing a resin and a surfactant (JP-A No. 2004-191465); and so on.

### DISCLOSURE OF THE INVENTION

### PROBLEMS TO BE SOLVED BY THE INVENTION

These methods enable to readily form an ultrafine pattern exceeding a wavelength resolution limit of photolithography by a method of applying a water-soluble composition or the like but have various problems. One of the problems is that, in a conventional pattern shrink material that uses a crosslinking agent, the amount of shrinkage in size is largely increased by adding the crosslinking agent but solubility thereof in pure water is lowered owing to generation of crosslinking and the insoluble material tends to remain and cause defects. This is a vital problem. For example, a water-soluble resin composition containing a crosslinking agent which is a typical material of a conventional water-soluble resin material for shrinkage processing may largely increase the amount of shrinkage in size by a chemical reaction due to a crosslinking agent that is an additive. However, a crosslinking reaction largely depends on a diffusion profile of the acid because a catalytic action is generated by diffusion of a remaining acid in the resist. When the acid diffuses from the resist to a water-soluble resin material, the profile of the acid depends on an acid distribution on exposure. The diffusion manner of an acid is very complicated and in particular, diffusion into a different medium is not well known. It is known from recent researches that the acid diffusion profile is disturbed when the acid is diffused into a different medium. Because of the disturbance of the acid diffusion profile, solubility contrast to water of the crosslinked portion and the uncrosslinked portion is lowered to result in causing defects on development.

Further, as a pattern size becomes smaller, the deterioration of the crosslinking contrast affects more gravely. In particular, in an ultrafine pattern of 100 nm or less, patterns in an undissolved portion connect each other to generate micro-bridges in many cases.

Thus, a conventional pattern shrink material has various problems and is not suitable for forming an ultrafine separation pattern with a gap of 100 nm or less in width between patterns. Accordingly, there is required a shrink material that is improved in an amount of pattern shrinkage, defects after shrinking and shrinkage of an asymmetrical pattern, is suitable for forming an ultrafine separation pattern with a gap of 100 nm or less in width between patterns and is capable of developing with water.

Accordingly, an object of the present invention is to provide a water-soluble resin composition for the formation of fine patterns, which does not use a crosslinking agent and, even without using a crosslinking agent, is capable of miniaturizing a pattern without reducing the amount of pattern shrinkage which is achieved when the shrinkage is conducted with a crosslinking agent, is able to achieve a constant amount of shrinkage irrespective of a pattern shape, and is reduced in generation of development defects or micro-bridges caused by the insoluble materials.

Further, another object of the invention is to provide a method for forming fine patterns with the water-soluble resin composition for the formation of fine patterns described above, wherein an amount of shrinkage of the pattern is large, the amount of shrinkage does not vary depending on a pattern shape, and a development defect caused by the insoluble materials and development defects of the micro-bridges or the like are reduced in amount.

Furthermore, another object of the invention is to provide a water-soluble resin composition for the formation of fine patterns, which is suitable for forming an ultrafine separation pattern with a gap of 100 nm or less in width between patterns and capable of developing with water; and a method for forming a miniaturized resist pattern with the water-soluble resin composition for the formation of fine patterns.

### MEANS FOR SOLVING THE PROBLEMS

As a result of intensive studies and investigations, the present inventors found that, when a water-soluble resin composition containing a particular resin and a particular amine compound is used, without using a crosslinking agent, scale-down of a resist pattern is conducted equal to or more than when a crosslinking agent is used, there is no problem of unevenness of a shrinking width depending to a shape of the resist pattern, development defects and so on are less generated, and development with water can be conducted. The present invention was completed based on the findings.

That is, the invention, as defined in the appended claims, relates to a water-soluble resin composition for the formation of fine patterns, which comprises (A) a water-soluble vinyl resin, (B) a compound having at least two amino groups in a molecule and (C) a solvent.

Further, the invention also relates to a method for forming fine patterns, which comprises a first step of forming a water-soluble resin film by applying the water-soluble resin composition for the formation of fine patterns on a resist pattern formed on a base substrate by lithographic steps; a second step of carrying out mixing of the water-soluble resin film and a resist film constituting the resist pattern; and a third step of removing the water-soluble resin film by water washing after the mixing.

### EFFECTS OF THE INVENTION

When a water-soluble resin composition for the formation of fine patterns of the invention is used, a fine pattern of 100 nm or less is formed by developing with water. Further, when a resist pattern is shrunk by crosslinking of a water-soluble resin with a crosslinking agent as ever, solubility contrast of a crosslinked portion and an uncrosslinked portion to water is reduced by disturbance of a diffusion profile of acid to generate development defects and micro-bridges. However, in the invention, as the water-soluble resin film is not modified by a crosslinking agent, there takes place no problem caused by the disturbance of a diffusion profile of acid as before. Furthermore, in the invention, a shrinkage of resist pattern can be achieved owing to an effect of amplification equal to or more than that of film modification caused by conventional acid crosslinking, and a thickness of the modified film can be controlled by controlling an amount of the compound having at least two amino groups in a molecule or a heating temperature on the mixing bake.

### BRIEF DESCRIPTION OF THE DRAWINGS

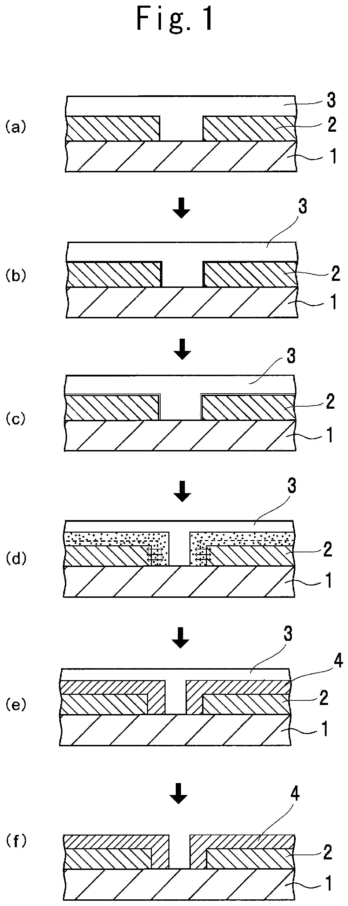

Fig. 1 shows an explanatory diagram for explaining a method for forming fine patterns by use of a water-soluble resin composition for the formation of fine patterns of the invention.

### BEST MODE FOR CARRYING OUT THE INVENTION

Hereinafter, a water-soluble resin composition for the formation of fine patterns of the invention and a method for forming fine patterns with the same will be more detailed with reference to Fig. 1.

In the beginning, as shown in Fig.1(a), a water-soluble resin composition for the formation of fine patterns of the invention is applied on a resist pattern 2 formed on a base substrate 1 to form a water-soluble resin film 3 on a resist pattern. Thereby, physical adsorption of a water-soluble resin composition occurs on a resist film as shown in Fig. 1(b). In the next place, as shown in Fig. 1(c), a compound having at least two amino groups in a molecule permeates into a resist film and reacts with a resist film to swell the resist film. Then, a substrate on which the resist film and the water-soluble resin film are carried is left to stand at room temperature to conduct mixing of these or is heated to conduct mixing of these (mixing bake). By these, the permeation of a compound having at least two amino groups in a molecule into the water-soluble resin and the reaction of these as well as the mixing of the resist layer with the water-soluble and the reaction of these are promoted. Then, as shown in Fig. 1(d), intermixing between the resist and the water-soluble resin composition occurs. As the result, as shown in Fig. 1(e), the water-soluble resin composition is modified and the intermixed layer with the resist expands to form a layer 4 insolubilized to water with an amplified film thickness as same as insolubilization by conventional hardening with a crosslinking agent. In the case where the mixing is conducted by heating, it is cooled down, and then the unmodified water-soluble resin composition is washed away with water to form a miniaturized pattern as shown in Fig. 1(f).

An amplified and insolubilized layer is formed according to the invention. We think that the reason is as mentioned below. However, the following explanation does not at all restrict the invention. That is, a remaining acid diffuses from a resist into a water-soluble resin composition layer during mixing bake. This is the same phenomenon as in the conventional methods. However as the amount of the acid is very slight compared with the amount of the compound having at least two amino groups in a molecule (amine compound) contained in the water-soluble resin composition, almost all of the acid is captured by amino groups of the amine compound which is permeated from a water-soluble resin composition into a resist film. The acid, therefore, does not substantially diffuse from the resist to the water-soluble resin composition in the invention, which is different from the conventional method. As a result, no decrease of the solubility contrast caused by disturbance of a profile of acid diffusion is occurred. Further, in the invention, a compound having at least two amino groups in a molecule permeates into the resist film, and the compound causes a reaction such as a salt formation or a bond formation due to intermolecular force with carboxylic acid, an ester functional group such as acetal or a phenol group having high polarity in a resist resin to swell a resist film; accordingly, the water-soluble resin becomes readily permeable into the resist film and mixing with the resist film is promoted. As free volumes of both of the resist and the water-soluble resin composition increase owing to heat energy during baking, the mixing of the water-soluble resin composition to the resist becomes easier. In addition, the free volume is further increased by a chemical reaction with the amine compound, and the mixing can be conducted more smoothly. Furthermore, the higher a baking temperature is set exceeding glass transition temperatures of both of the resist and the water-soluble resin composition, the more largely the free volume increases, thereby the mixing occurring more actively. In the invention, larger increase of thickness of a modified film than a conventional system containing a crosslinking agent is achieved by adding a compound having at least two amino groups in a molecule. In addition, as the film thickness of a modified film can be increased or reduced by controlling the amount of the compound having at least two amino groups in a molecule in the invention, the amount of pattern shrinkage in size can also be controlled. Further, in the invention, the film thickness of a modified film can be also increased or reduced by controlling a heating temperature during mixing bake and thereby the amount of pattern shrinkage in size can be controlled.

Hereinafter, a water-soluble vinyl resin (A), a compound (B) having at least two amino groups in a molecule and a solvent (C), which constitute a water-soluble resin composition for the formation of fine patterns of the invention, as well as additives of optional components other than these will be described.

In the water-soluble vinyl resin (A) used in the water-soluble resin composition for the formation of fine patterns of the invention, it is preferred that, for example, at least one of vinyl monomers containing a nitrogen atom is used as a monomer component constituting a polymer. Examples of such vinyl monomer include allylamine, acrylamide, vinylpyrrolidone, vinylcaprolactam, and vinylimidazole.

Examples of the water-soluble vinyl resin (A) preferably used in the invention include a homopolymer of a nitrogen-containing vinyl monomer, a copolymer of two or more of nitrogen-containing vinyl monomers, and a copolymer of a nitrogen-containing vinyl monomer and other vinyl monomer, that is, a vinyl monomer which does not contain a nitrogen atom.

The reason why a monomer other than a nitrogen-containing monomer is used as a copolymer component is for inhibiting a monomer component in a copolymer from blocking. Localization of a chemical reaction due to blocking of a vinylimidazole monomer is inhibited by use of the monomer other than a nitrogen-containing monomer and an imbalance between hydrophilicity and hydrophobicity of the polymer is improved. Accordingly, any vinyl monomer that does not contain a nitrogen atom may be used as long as the aforementioned object is achieved. Preferred examples of the monomer include (meth)acrylic acid, (meth)acrylic acid ester, hydroxyalkyl (meth)acrylate, vinyl alkylate, and vinylhydroxy alkylate. In addition, "(meth) acryl" is used to name generically "acryl" and "methacryl" in the invention.

Further, vinylimidazole is preferably used as one of copolymer monomer components in the invention. This is because when vinylimidazole is used as a monomer component for a copolymer, a N-heteroring in a vinylimidazole monomer part in a copolymer resin causes a reaction such as a salt formation or an intermolecular bond formation with carboxylic acid, an ester compound such as acetal and a functional group having a high polarity such as phenol in the resist to readily form an insolubilized layer. Furthermore, as a vinylimidazole monomer moiety has high hydrophobicity, when a hydrophilic group is introduced into a monomer moiety other than the vinylimidazole monomer moiety, a balance between hydrophilicity and hydrophobicity of the polymer may be relatively easily controlled. It works advantageously for improving a mixing property with a resist.

Preferred examples of a copolymer in which a vinylimidazole monomer is used include a copolymer of a nitrogen-containing vinyl monomer other than vinylimidazole (a-1) and vinylimidazole (a-2), such as a copolymer of at least one monomer selected from a group consisting of allylamine, acrylamide, vinylpyrrolidone and vinylcaprolactam and vinylimidazole; a ternary copolymer made of a nitrogen-containing vinyl monomer other than vinylimidazole (a-1), vinylimidazole (a-2) and a vinyl monomer (b) that does not contain a nitrogen atom other than these monomers, such as a ternary copolymer of at least one monomer selected from a group consisting of allylamine, acrylamide, vinylpyrrolidone and vinylcaprolactam, vinylimidazole and a vinyl monomer that does not contain a nitrogen atom other than these monomers.

In the copolymer, the ratio of the nitrogen-containing vinyl monomer other than vinylimidazole (a-1), vinylimidazole (a-2) and the vinyl monomer (b) that does not contain a nitrogen atom may be set arbitrarily without particular restriction. However, it is usually preferred that (a-1) : (a-2) is 0.1 : 99. 9 to 99.9 : 0.1 by a mole ratio, and a total amount of (a-1) and (a-2) : (b) is 70 : 30 to 99.9 : 0.1 by mole ratio.

Among the preferred polymers, examples of particularly preferred polymer include a copolymer of vinylpyrrolidone and vinylimidazole; and a copolymer of vinylpyrrolidone, vinylimidazole, and at least one of (meth)acrylic acid ester, hydroxyalkyl (meth)acrylate, vinyl alkylate and vinylhydroxy alkylate, that is represented by a formula (1): 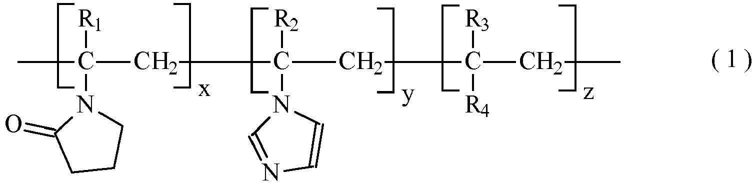 wherein, R₁, R₂ and R₃ each independently represent a hydrogen atom or a methyl group, R₄ represents an alkyloxycarbonyl group, a hydroxyalkyloxycarbonyl group, an alkylcarbonyloxy group or a hydroxyalkylcarbonyloxy group wherein alkyl represents a straight or branched alkyl having 1 to 6 carbon atoms, and x, y and z each represent an integer from 5 to 1,000.

Examples of groups preferable as the alkyloxycarbonyl group, a hydroxyalkyloxycarbonyl group, an alkylcarbonyloxy group or a hydroxyalkylcarbonyloxy group include -COOCH₃, -COO-(CH₂)ₛ-CH₂-OH, -OCOCH₃, and -OCO-(CH₂)ₜ-CH₂-OH, wherein sand t each represent an integer from 1 to 5.

A molecular weight of the water-soluble resin of the invention is not particularly restricted. However, the molecular weight is, in terms of weight average molecular weight, preferably from 5,000 to 500,000 and more preferably from 10,000 to 50, 000 from the viewpoint of a coating property and a filtering property. When the molecular weight is less than 5,000, the coating property is poor to be difficult to obtain a homogeneous coated film and stability with time of the coated film is deteriorated. On the other hand, when the molecular weight exceeds 500,000, stringiness is caused during coating or spreading over a resist surface is poor to be difficult to obtain a homogeneously coated film with a little dropping amount. Further, permeability of a filter becomes very poor in many cases.

On the other hand, the compound (B) having at least two amino groups in a molecule, which is used in a water-soluble resin composition for the formation of fine patterns of the invention, permeates into a resist side at the time of mixing, more preferably mixing bake and reacts to expand the resist. A resin in the water-soluble composition, thereby, is made more readily permeable to enable smooth intermixing. As the compound which is preferably used as the compound (B) having at least two amino groups in a molecule, there are exemplified a compound having in a molecule a group represented by the formula (2): 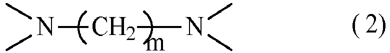 wherein m represents an integer from 1 to 8. Two amino groups in the formula (2) may be any one of a primary amino group, a secondary amino group and a ternary amino group.

As a compound having a group like this in a molecule, there is exemplified a compound represented by a formula (3): 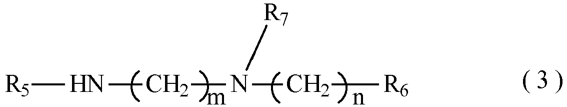 wherein, R₅ and R₇ each independently represent a hydrogen atom or a linear, branched or cyclic alkyl group having 1 to 6 carbon atoms, R₆ represents a hydrogen atom, -OH, -COOH, -CH₂OH, -N(CH₂)pR₈, -N(CH₂)_{q}OH, a linear, branched or cyclic alkyl group having 1 to 6 carbon atoms, an alkenyl group, an aryl group or an alalkyl group, R₈ represents a hydrogen atom, -OH or -COOH, and m, n, p and q each represent an integer from 1 to 8.

In the formula (3), examples of a linear, branched or cyclic alkyl group having 1 to 6 carbon atoms of R₅, R₆ and R₇ include a methyl group, an ethyl group, an n-propyl group, an isopropyl group, an n-butyl group, an isobutyl group, a s-butyl group, a t-butyl group, a n-pentyl group, a n-hexyl group, a cyclopropyl group, a cyclopentyl group, and a cyclohexyl group.

Further, examples of the alkenyl group, aryl group and alalkyl group of R₆ in the formula (3) include, for example, a vinyl group, a propylene group, a butylene group, a pentylene group, a hexylene group, a phenyl group, a naphthyl group, a benzyl group and a phenylethyl group.

Specific examples of the compound represented by the formula (3) include, for example, 2-(2-aminoethylamino)ethanol, 2-(2-aminopropylamino)ethanol, 2-(2-aminobutylamino)ethanol, 2-(2-aminoethylamino)propanol, 2-(2-aminopropylamino)propanol, 2-(2-aminobutylamino)propanol,
2-(2-aminoethylamino)isopropanol,
2-(2-aminopropylamino)isopropanol,
2-(2-aminobutylamino)isopropanol,
2-(2-aminoethylamino)butanol, 2-(2-aminopropylamino)butanol, 2-(2-aminobutylamino)butanol,
2-(2-methylaminoethylamino)ethanol,
2-(2-methylaminopropylamino)ethanol,
2-(2-methylaminobutylamino)ethanol,
2-(2-methylaminoethylamino)propanol,
2-(2-methylaminopropylamino)propanol,
2-(2-methylaminobutylamino)propanol,
2-(2-methylaminoethylamino)isopropanol,
2-(2-methylaminopropylamino)isopropanol,
2-(2-methylaminobutylamino)isopropanol,
2-(2-methylaminoethylamino)butanol,
2-(2-methylaminopropylamino)butanol,
2-(2-methylaminobutylamino)butanol,
2-(2-ethylaminoethylamino)ethanol,
2-(2-ethylaminopropylamino)ethanol,
2-(2-ethylaminobutylamino)ethanol,
2-(2-ethylaminoethylamino)propanol,
2-(2-ethylaminopropylamino)propanol,
2-(2-ethylaminobutylamino)propanol,
2-(2-ethylaminoethylamino)isopropanol,
2-(2-ethylaminopropylamino)isopropanol,
2-(2-ethylaminobutylamino)isopropanol,
2-(2-ethylaminoethylamino)butanol,
2-(2-ethylaminopropylamino)butanol,
2-(2-ethylaminobutylamino)butanol,
2-(2-aminoethylmethylamino)ethanol,
2-(2-methylaminomethylamino)ethanol,
2-(2-aminomethylamino)propanol,
2-(2-aminomethylamino)isopropanol,
2-(2-aminomethylamino)butanol,
2-(2-amino-1,1-dimethylethylamino)ethanol,
2-(2-amino-1,1-dimethylethylamino)propanol, and
2-(2-amino-1,1-dimthylethylamino)butanol as a typical compound.

Examples of the compound having at least two amino groups in a molecule other than those represented by the formula (3) include compounds which is a heterocyclic compound containing two nitrogen atoms such as imidazolidine, piperadine and imidazolidinone, the ring of which is formed by incorporation of R₅, R₇ and two amino groups in the formula (3). Examples thereof include 1-(hydroxymethyl)imidazolidinone,
1-(2-hydroxyethyl)imidazolidinone,
1-(2-hydroxypropyl)imidazolidinone, 2-(1-piperadinyl)ethanol, and 2-(4-amino-1-piperadinyl)ethanol.

Examples of other compound having at least two amino groups in a molecule include ((aminoacetyl)amino)acetic acid, ((2-aminopropanoyl)amino)acetic acid, N-(aminoacetyl)alanine, (aminoacetylmethylamino)acetic acid,
2-(2-dimethylaminoethylmethylamino)ethanol,
2-(2-(2-hydroxyethyl)amino)ethyl)aminoethanol,
(2-(2-amino-2-methylpropyl)amino)-2-methyl-1-propanol, 1,4-bis(2-hydroxyethyl)piperadine,
2-(4-morpholinyl)ethaneamine, and a compound in which all of two amino groups of the formula (2) are substituted by a - (CH₂)ₙR₆ group, wherein R₆ and n are same as those defined in the formula (3), such as N,N-bis(2-hydroxyethyl)ethylenediamine.

Among these, compounds represented by the formula (3) are preferred and, among the compounds represented by the formula (3), aminoalcohols are preferred. Further, polyvalent aminoalcohols can enhance mixing with the water-soluble polymer by formation of a mutual ion bond with carboxylic acid or a hydroxyl group in a water-soluble polymer. Therefore, these compounds are also preferred as a compound (B) of the invention. In the composition for the formation of fine patterns of the invention, the weight ratio (A) : (B) of the water-soluble vinyl resin (A) and the compound (B) having at least two amino groups in a molecule is preferably 70 : 30 to 99.9 : 0.1.

Furthermore, a solvent (C) that is used in the composition for the formation of fine patterns of the invention will be described hereinafter. As the solvent (C), water is preferably used. Water used as a solvent (C) is not particularly restricted as long as it is water, but water from which organic impurities and metallic ions are removed by distillation, ion exchange process, filtering process or various adsorption treatments is preferred.

As the solvent (C), a water-soluble organic solvent may be used together with water to improve a coating property or the like. The water-soluble organic solvent is not particularly restricted as long as it is a solvent soluble 0.1% by weight or more in water. Examples thereof include, for example, alcohols such as methyl alcohol, ethyl alcohol, and isopropyl alcohol; ketones such as acetone, methyl ethyl ketone, 2-heptanone, and cyclohexanone; esters such as methyl acetate and ethyl acetate; ethylene glycol monoalkyl ethers such as ethylene glycol monomethyl ether and ethylene glycol monoethyl ether; ethylene glycol monoalkyl ether acetates such as ethylene glycol monomethyl ether acetate and ethylene glycol monoethyl ether acetate; propylene glycol monoalkyl ethers such as propylene glycol monomethyl ether and propylene glycol monoethyl ether; propylene glycol monoalkyl ether acetates such as propylene glycol monomethyl ether acetate and propylene glycol monoethyl ether acetate; lactic acid esters such as methyl lactate and ethyl lactate; aromatic hydrocarbons such as toluene and xylene; amides such as N,N-dimethylacetamide and N-methyl pyrrolidone; and lactones such as y-butylolactone. As preferable solvent, lower alcohols such as methyl alcohol, ethyl alcohol and isopropyl alcohol are exemplified. These solvents may be used singularly or in a mixture of at least two thereof. When there is no hindrance to mixing with a resist film and to development with water, an organic solvent that does not contain water may be used as a solvent.

A surfactant may be added as an optional component to improve a coating property in the water-soluble resin composition of the invention. Examples of the surfactant include, for example, acetylene alcohols, acetylene glycols, polyethoxylates of acetylene alcohols, polyethoxylates of acetylene glycols, and so on. Examples of the acetylene alcohols and acetylene glycols include, for example, 3-methyl-1-butine-3-ol, 3-methyl-1-pentine-3-ol, 3,6-dimethyl-4-octine-3,6-diol, 2,4,7,9-tetramethyl-5-decine-4,7-diol,
3,5-dimethyl-1-hexine-3-ol, 2,5-dimethyl-3-hexine-2,5-diol, 2,5-dimethyl-2,5-hexanediol, and so on. The surfactants may be used singularly or in a mixture of at least two thereof. A blending amount thereof is usually 50 to 2,000 ppm and preferably 100 to 1,000 ppm relative to the composition for the formation of fine patterns of the invention.

In a method of the invention for forming a miniaturized pattern, the water-soluble resin composition for the formation of fine patterns of the invention is applied on a resist pattern which is formed on a base substrate according to an ordinary lithography step to form a water-soluble resin film on the resist pattern. As the base substrate, a semiconductor substrate such as silicon wafer or a glass substrate for LCD, PDP or the like may be appropriately used. The base substrate may be one on which a conductive film, a wiring, a semiconductor or the like is provided. The resist pattern is formed, for example, in such a manner that a photoresist is applied on a base substrate by a conventional method such as a spin coating method, pre-baked (for example, baking is conducted at a temperature of 70 to 140°C for about 1 minute), followed by exposing with UV-rays such as g-line or i-line, deep UV-rays such as KrF excimer laser light or ArF excimer laser light, X-rays or an electron beam, as required. Then, it is post-exposure baked (PEB) (for example, baking temperature is 50 to 140°C), followed by developing and, as required, baking after development (for example, baking temperature is 60 to 120°C). A water-soluble resin composition may be applied by a method arbitrarily selected from conventional methods such as a spin coating method, a spray coating method, a dipping method and a roller coating method. At this time, the amount of the water-soluble resin composition applied may be set at an arbitrary amount. However, a dry thickness of about 0.08 to 0.3 µm is preferred. After application of the water-soluble resin composition, pre-bake is conducted, for example, at 60 to 90°C for 15 to 90 seconds, as required, to form a water-soluble resin film.

In the next place, mixing of the resist pattern formed on a substrate and a water-soluble resin film are carried out. The mixing may be carried out at ordinary temperature; however it is preferred to be carried out by a heating process, i.e. mixing bake. Permeation of a compound (B) into a resist film and reaction of the compound (B) with the resist is promoted by heating. As the result, swelling of the resist film is promoted, a resin in the water-soluble composition can be more easily permeated into the resist film, and intermixing is more smoothly carried out, thereby shrinkage of a fine pattern being promoted. In addition, by heating, a reaction of a nitrogen-containing water-soluble vinyl resin with carboxylic acid, an ester functional group such as acetal, a phenol group having a high polarity, or the like in a resist resin is also promoted to increase a free volume in the resist. The temperature and the baking time of the mixing bake may be appropriately determined depending on a resist used, materials used in the water-soluble resin composition, the thickness of a crosslinked film and so on. The temperature of the mixing bake and the baking time are usually set about 100 to 180°C for the temperature and about 30 to 90 seconds for the time, without restricting thereto. The higher the baking temperature becomes exceeding glass transition temperatures of the resist and the water-soluble composition, the larger the increase of the free volume becomes; accordingly, the activity of the mixing becomes higher. The desired amount of pattern shrinkage is obtained by controlling a bake temperature.

Further, when the mixing is conducted by heating, a modified water-soluble resin film is cooled down and then developed with water, a mixture of water and a water-soluble organic solvent, an aqueous solution of alkaline such as TMAH (tetramethylammonium hydroxide) or the like to dissolve and remove an unmodified water-soluble resin film. Thereby, a trench pattern or a hole pattern is effectively miniaturized.

### EXAMPLES

Hereinafter, the invention will be specifically described with reference to Examples, but it should be understood that the invention is not restricted by the Examples by no means.

### Example 1

10 g of a copolymer of a vinylpyrrolidone monomer and a vinylimidazole monomer (mass ratio is 2:1), which is manufactured by AZ Electronic Materials (Japan) K.K. (hereinafter, abbreviated as "AZ-EM (Japan) K.K."), were dissolved in 90 g of pure water to obtain a solution. Into the solution, 5 g of 2-(2-aminoethylamino)ethanol was added. It was stirred thoroughly and then filtered by passing through a 0.05 µm filter to prepare a water-soluble resin composition for the formation of fine patterns.

On the other hand, a resist composition, AZ AX1120P (trade name) manufactured by AZ-EM (Japan) K.K. was applied on a silicon wafer substrate and baked at 120°C for 90 seconds to form a resist film of 175 nm in thickness. The substrate was exposed by use of an ArF exposure unit, NIKON ArF-Scanner NSR-S360D (trade name) manufactured by Nikon, followed by baking at 120°C for 90 seconds. The substrate was developed with a 2.38% by mass aqueous tetramethylammonium hydroxide solution for 60 seconds and then washed with water for 30 seconds, thereby a separation pattern having a gap of 75 nm in width between patterns being formed. In the next place, the water-soluble resin composition prepared above was applied on the resist pattern, heated at 150°C for 60 seconds, and cooled at 23°C for 30 seconds. It was washed with pure water for 60 seconds and an unreacted water-soluble resin composition was completely removed to obtain resist patterns having a gap of 50 nm in width between resist patterns finally.

In the foregoing steps, there were carried out defect inspections of patterns on a wafer before and after the modification step with the water-soluble resin. The defect inspection was conducted by measuring the number of defects with KLA. In Examples and a Comparative Example shown below, the defect inspection was conducted in the same manner as that mentioned above.

The result of defect inspection of fine patterns obtained in the aforementioned steps of Example 1 is that the number of defects before the modification step was 200 and the number of defects after the modification step was 230. From this, it is found that very little increases of the defect number occurred by applying the water-soluble resin composition.

### Example 2

10 g of a copolymer of a vinylpyrrolidone monomer and a vinylimidazole monomer (mass ratio is 1:1), which is manufactured by AZ-EM (Japan) K.K. , was dissolved in 90 g of pure water to obtain a solution. Into the solution, 4 g of
2-(2-aminoethylamino)propanol was added and then filtered to prepare a water-soluble resin composition for the formation of fine patterns.

On the other hand, separation resist patterns having a gap of 75 nm in width was formed in the same manner as Example 1. In the next place, the water-soluble resin composition prepared above was applied on the resist patterns, followed by processing in the same manner as Example 1, and thereby resist patterns having a gap of 45 nm between resist patterns were finally obtained, from which an unreacted water-soluble resin composition was completely removed.

The result of defect inspection of fine patterns obtained in the steps of Example 2 is that the number of defects before the modification step was 200 and the number of defects after the modification step was 250. From this, it is found that very little increases of the defect number occurred by applying the
water-soluble resin composition.

### Example 3

10 g of a copolymer of a vinylpyrrolidone monomer and a vinylimidazole monomer (mass ratio is 1:2), which is manufactured by AZ-EM (Japan) K.K. , was dissolved in 90 g of pure water to obtain a solution. Into the solution, 3 g of
2-(2-amino-1,1-dimethylethylamino)ethanol was added and thoroughly stirred. Then it was filtered to prepare a water-soluble resin composition for the formation of fine patterns.

On the other hand, resist patterns having a gap of 80 nm in width between patterns were formed on a silicon wafer substrate in the same manner as Example 1. In the next place, the water-soluble resin composition prepared above was applied on the resist patterns, followed by treating in the same manner as Example 1, and thereby resist patterns having a gap of 55 nm in width between resist patterns were finally obtained, from which an unreacted water-soluble resin composition was completely removed.

The result of defect inspection of fine patterns obtained in the steps of Example 3 is that the number of defects before the modification step was 270 and the number of defects after the modification step was 300. From this, it is found that very little increases of the defect number occurred by applying the
water-soluble resin composition.

### Example 4

Polymerization inhibitors were extracted and washed away from a vinyl pyrrolidone monomer, a vinyl imidazole monomer and a (meth)acrylate monomer using a 10% by weight aqueous sodium hydroxide solution. 0.9 g of AIBN (azobisisobutylonitrile) that is a polymerization initiator was dissolved in 100 g of isopropanol and then the solution was heated. After the temperature of the solution became 65°C, 12 g of the vinylpyrrolidone monomer, 8 g of the vinylimidazole monomer and 2 g of the (meth)acrylate monomer were simultaneously and gradually dropped from burettes. After a polymerization reaction for 5 hours, the reaction solution was cooled at normal temperature, followed by distilling under reduced pressure to concentrate the solution. The resultant concentrated solution was precipitated from diethyl ether. Further, the precipitate obtained was dissolved again in isopropanol and then precipitated again from diethyl ether to be purified. 10 g of thus-obtained ternary copolymer of vinylpyrrolidone monomer, vinylimidazole monomer and (meth)acrylate monomer (mass ratio is 6:4:1) was dissolved in 90 g of pure water, followed by adding 7 g of 1-(2-hydroxymethyl)imidazolidinone. It was stirred thoroughly and filtered to prepare a water-soluble resin composition for the formation of fine patterns.

In the next place, separation resist patterns having a gap of 80 nm in width was formed in the same manner as Example 1 except that the thickness of a resist film formed was set at 200 nm. The water-soluble resin composition prepared above was applied on the resist patterns and then processed in the same manner as Example 1. Resist patterns having a gap of 50 nm in width between resist patterns were finally obtained, from which an unreacted water-soluble resin composition was completely removed.

The result of defect inspection of fine patterns obtained in the steps of Example 4 is that the number of defects before the modification step was 100 and the number of defects after the modification step was 157. From this, it is found that very little increases of the defect number occurred by applying the water-soluble resin composition.

### Example 5

In the beginning, 10 g of a ternary polymer obtained by radical polymerization of a vinylpyrrolidone monomer, a vinylimidazole monomer and a hydroxyethyl acrylate monomer (mass ratio is 2:2:1) was dissolved in 80 g of pure water to obtain a polymer solution. Into the solution, 5 g of 2-(2-aminoethylamino)ethanol was added and thoroughly mixed, followed by filtration to prepare a water-soluble resin composition for the formation of fine patterns.

On the other hand, separation resist patterns having a gap of 80 nm in width was formed on a silicon wafer substrate in the same manner as Example 4. In the next place, the water-soluble resin composition prepared above was applied on the resist patterns, followed by processing in the same manner as Example 1 to obtain finally resist patterns having a gap of 50 nm in width between resist patterns, from which an unreacted water-soluble resin composition was completely removed.

The result of defect inspection of fine patterns obtained in the steps of Example 5 is that the number of defects before the modification step was 150 and the number of defects after the modification step was 198. From this, it is found that very little increases of the defect number occurred by applying the water-soluble resin composition.

### Comparative Example 1

In Example 2, a water-soluble resin composition containing a crosslinking agent manufactured by AZ-EM (Japan) K.K. instead of 2-(2-aminoethylamino)propanol was applied on a substrate on which a resist pattern was formed and then it was processed in the same steps as Example 1. The width of a gap between patterns was changed from 80 nm to 65 nm. However, micro-bridges were formed on a fine pattern.

The result of defect inspection of fine patterns obtained in the steps of Comparative Example 1 is that the number of defects before the modification step was 230 and the number of defects after the modification step was 1500. From this, it is found that the number of defects was vastly increased by application of the water-soluble resin composition.

From the foregoing Examples and Comparative Example, it is found that, in an ultrafine pattern of 100 nm or less, formation of fine patterns capable of developing with pure water is possible according to the invention. When used a conventional water-soluble resin material for fine processing, micro-bridges are formed in an ultrafine pattern of 100 nm or less owing to a crosslinking mechanism of a resist polymer and water-soluble resin by a crosslinking agent. However, in the invention, the mixing of a water-soluble polymer and a resist layer is enhanced by the mutual ionic bond with carboxylic acid or a hydroxyl group in a resist polymer using a compound having at least two amino groups in a molecule, and a large scale-down of a fine pattern can be achieved. In addition, development with water can be realized and occurrence of development defects such as micro-bridges or the like after development are inhibited.

## Claims

1. Amended claims in response to the Communication pursuant to Article 94(3) EPC dated August 28, 2014 (Auxiliary Request): 1. A water-soluble resin composition for the formation of fine patterns, which comprises (A) a water-soluble vinyl resin, (B) a compound having at least two amino groups in the molecule and (C) a solvent, wherein the water-soluble vinyl resin (A) is a water-soluble ternary copolymer represented by the formula (1) : 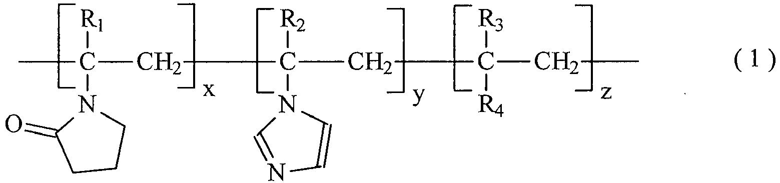 wherein R₁, R₂ and R₃ each independently represent a hydrogen atom or a methyl group, R₄ represents an alkyloxycarbonyl group, a hydroxyalkyloxycarbonyl group, an alkylcarbonyloxy group or a hydroxyalkylcarbonyloxy group wherein alkyl represents a straight or branched alkyl having 1 to 6 carbon atoms, and x, y and z each represent an integer from 5 to 1,000,wherein the compound having at least two amino groups in the molecule (B) is a compound having a group, in a molecule, represented by the formula (3): 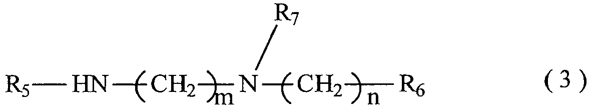 wherein R₅ and R₇ each independently represent a hydrogen atom or a linear, branched or cyclic alkyl group having 1 to 6 carbon atoms, R₆ represents a hydrogen atom, -OH, -COOH, -CH₂OH,
-N(CH₂)ₚR₈, -N(CH₂)_{q}OH, a linear, branched or cyclic alkyl group having 1 to 6 carbon atoms, an alkenyl group, an aryl group or an alalkyl group, R₈ represents a hydrogen atom, -OH or -COOH, and m, n, p and q each represent an integer from 1 to 8.

2. The water-soluble resin composition for the formation of fine patterns according to claim 1, wherein a weight ratio (A) : (B) of the water-soluble vinyl resin (A) and the compound (B) having at least two amino groups in a molecule is 70 : 30 to 99.9 : 0.1.

3. The water-soluble resin composition for the formation of fine patterns according to any one of claims 1 to 2, which further comprises a surfactant.

4. A method for forming a fine pattern, which comprises a first step of forming a water-soluble resin film by applying the water-soluble resin composition for the formation of fine patterns described in any one of claims 1 to 3 on a resist pattern formed on a base substrate by lithographic steps; a second step of carrying out mixing of the water-soluble resin film and a resist film constituting the resist pattern; and a third step of removing the water-soluble resin film by water washing after the mixing

5. The method for forming a fine pattern according to claim 4, the mixing is carried out by heating.

6. The use of a water soluble resin composition according to any one of claims 1 to 3 for the formation of a resist fine pattern.

## Patentansprüche

1. Eine wasserlösliche Harzzusammensetzung für die Bildung von Feinstrukturen, die (A) ein wasserlösliches Vinylharz, (B) eine Verbindung umfassend mindestens zwei Aminogruppen in dem Molekül und (C) ein Lösungsmittel enthält, wobei das wasserlösliche Vinylharz (A) ein wasserlösliches ternäres Copolymer dargestellt durch die Formel (1) ist: 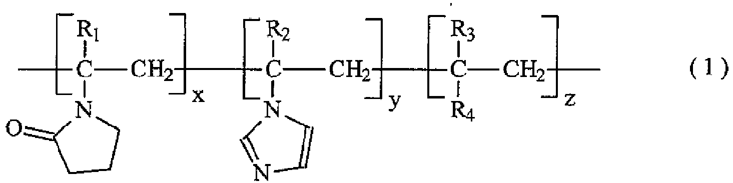 wobei R₁, R₂ und R₃ jeweils unabhängig ein Wasserstoffatom oder eine Methylgruppe darstellen, R₄ eine Alkyloxycarbonylgruppe, eine Hydroxyalkyloxycarbonylgruppe, eine Alkylcarbonyloxygruppe oder eine Hydroxyalkylcarbonyloxygruppe darstellt, wobei Alkyl ein unverzweigtes oder verzweigtes Alkyl umfassend 1 bis 6 Kohlenstoffatome darstellt und x, y und z jeweils eine ganze Zahl von 5 bis 1.000 darstellen, wobei die Verbindung umfassend mindestens zwei Aminogruppen in dem Molekül (B) eine Verbindung umfassend eine Gruppe, in einem Molekül, dargestellt durch die Formel (3) ist: 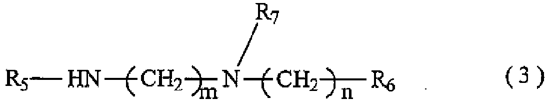 wobei R₅ und R₇ jeweils unabhängig ein Wasserstoffatom oder eine lineare, verzweigte oder cyclische Alkylgruppe umfassend 1 bis 6 Kohlenstoffatome darstellen, R₆ ein Wasserstoffatom, -OH, -COOH, -CH₂OH, -N(CH₂)ₚR₈, - N(CH₂)_{q}OH, eine lineare, verzweigte oder cyclische Alkylgruppe umfassend 1 bis 6 Kohlenstoffatome, eine Alkenylgruppe, eine Arylgruppe oder eine Alalkylgruppe darstellt, R₈ ein Wasserstoffatom, -OH oder -COOH darstellt und m, n, p und q jeweils eine ganze Zahl von 1 bis 8 darstellen.

2. Wasserlösliche Harzzusammensetzung für die Bildung von Feinstrukturen nach Anspruch 1, wobei ein Gewichtsverhältnis (A) : (B) von dem wasserlöslichen Vinylharz (A) und der Verbindung (B) umfassend mindestens zwei Aminogruppen in einem Molekül 70 : 30 bis 99,9 : 0,1 ist.

3. Wasserlösliche Harzzusammensetzung für die Bildung von Feinstrukturen nach einem der Ansprüche 1 bis 2, die ferner ein Tensid enthält.

4. Ein Verfahren zur Bildung einer Feinstruktur, das einen ersten Schritt des Bildens eines wasserlöslichen Harzfilms durch Auftragen der wasserlöslichen Harzzusammensetzung für die Bildung von Feinstrukturen beschrieben in einem der Ansprüche 1 bis 3 auf eine Resiststruktur, gebildet auf einem Basissubstrat durch lithographische Schritte; einen zweiten Schritt des Ausführens des Mischens des wasserlöslichen Harzfilms und eines Resistfilms die Resiststruktur bildend; und einen dritten Schritt des Entfernens des wasserlöslichen Harzfilms durch Waschen mit Wasser nach dem Mischen umfasst.

5. Verfahren zur Bildung einer Feinstruktur nach Anspruch 4, das Mischen wird durch Erwärmen ausgeführt.

6. Die Verwendung einer wasserlöslichen Harzzusammensetzung nach einem der Ansprüche 1 bis 3 für die Bildung einer Resistfeinstruktur.

## Revendications

1. Composition de résine hydrosoluble pour la formation de motifs fins, qui comprend (A) une résine vinylique hydrosoluble, (B) un composé ayant au moins deux groupes amino dans la molécule et (C) un solvant, dans laquelle la résine vinylique hydrosoluble (A) est un copolymère ternaire hydrosoluble représenté par la formule (1) : 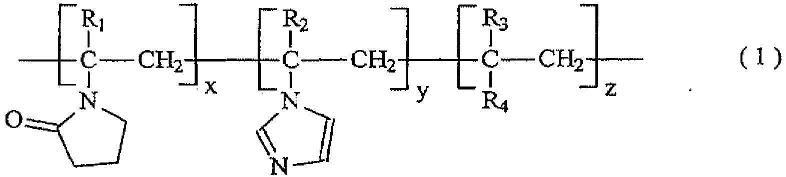 dans laquelle R₁, R₂ et R₃ représentent chacun indépendamment un atome d'hydrogène ou un groupe méthyle, R₄ représente un groupe alkyloxycarbonyle, un groupe hydroxyalkyloxycarbonyle, un groupe alkylcarbonyloxy ou un groupe hydroxyalkylcarbonyloxy, dans lesquels l'alkyle représente un alkyle droit ou ramifié ayant 1 à 6 atomes de carbone, et x, y et z représentent chacun un nombre entier de 5 à 1 000, dans laquelle le composé ayant au moins deux groupes amino dans la molécule (B) est un composé ayant, dans une molécule, un groupe représenté par la formule (3) : 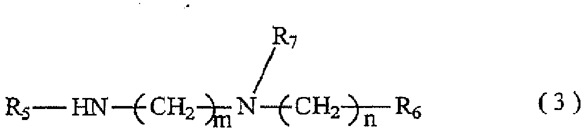 dans laquelle R₅ et R₇ représentent chacun indépendamment un atome d'hydrogène ou un groupe alkyle linéaire, ramifié ou cyclique ayant 1 à 6 atomes de carbone, R₆ représente un atome d'hydrogène, -OH, -COOH, -CH₂OH, -NCH₂)ₚR₈, -N(CH₂)_{q}OH, un groupe alkyle linéaire, ramifié ou cyclique ayant 1 à 6 atomes de carbone, un groupe alcényle, un groupe aryle ou un groupe aralkyle, R₈ représente un atome d'hydrogène, -OH ou -COOH et m, n, p et q représentent chacun un nombre entier de 1 à 8.

2. Composition de résine hydrosoluble pour la formation de motifs fins selon la revendication 1, dans laquelle un rapport pondéral (A) : (B) de la résine vinylique hydrosoluble (A) et du composé (B) ayant au moins deux groupes amino dans une molécule est de 70:30 à 99,9:0,1.

3. Composition de résine hydrosoluble pour la formation de motifs fins selon l'une quelconque des revendications 1 à 2, qui comprend en outre un tensioactif.

4. Procédé pour la formation d'un motif fin, qui comprend une première étape consistant à former un film de résine hydrosoluble par application de la composition de résine hydrosoluble pour la formation de motifs fins décrite dans l'une quelconque des revendications 1 à 3 sur un motif de réserve formé sur un substrat de base par des étapes lithographiques ; une deuxième étape consistant à effectuer le mélange du film de résine hydrosoluble et d'un film de réserve constituant le motif de réserve ; et une troisième étape consistant à enlever le film de résine hydrosoluble par lavage à l'eau après le mélange.

5. Procédé pour la formation d'un motif fin selon la revendication 4, le mélange étant effectué par chauffage.

6. Utilisation d'une composition de résine hydrosoluble selon l'une quelconque des revendications 1 à 3 pour la formation d'un motif fin de réserve.
